# EUROPEAN PATENT APPLICATION

(11) **EP 4 819 378 A1**
(43) Date of publication of application: **07.10.2026**
(21) Application number: 25167331.5
(22) Date of filing: 31.03.2025
(51) Int. Cl.: H01P 3/12, H01P 5/02, H01P 1/02

(54) **AIR-FILLED WAVEGUIDE ASSEMBLY WITH BRIDGING LAYER**

(71) Applicant: NXP USA, Inc., Austin, TX 78735 (US)
(72) Inventor: SYED, Waqas Hassan, 5656AG Eindhoven (NL); BUIJSMAN, Adrianus, 5656AG Eindhoven (NL); Van STRATEN, Freek Egbert, 5656AG Eindhoven (NL); SYEDA, Rabia, 5656AG Eindhoven (NL); CARLUCCIO, Goirgio, 5656AG Eindhoven (NL); NANDAGOPAL, Harish, 5656AG Eindhoven (NL); GÜLPEN, Jan, 5656AG Eindhoven (NL)
(74) Representative: Schwarzweller, Thomas

(57) **Abstract**

According to the present disclosure, there is provided an air-filled waveguide, AWG, assembly for use with a launcher-in-package semiconductor device, and comprising a stack of; a first laminate structure configured to be coupled to a semiconductor die, and having a first aperture therethrough; a second laminate structure affixed to the first laminate structure, having a second aperture, aligned with the first aperture, therethrough, and having a main AWG there-along; and a third laminate structure affixed to the second laminate structure, and having at least one bridging AWG there-along; wherein the AWG assembly is arranged to guide a microwave or millimetre-wave signal between the semiconductor die and the AWG in the second laminate, through the first and second aperture and along the bridging AWG.

## Description

### FIELD OF THE DISCLOSURE

This present disclosure relates to launcher-in-package semiconductor packages and assemblies, and in particular to those using air-filled waveguides (AWGs).

### BACKGROUND

Semiconductor devices designed to operate at microwave and millimetre wave frequencies (of the order of a few gigahertz, to a few hundred gigahertz), may include an integrated launcher, so as to direct the microwave or millimetre wave signals into air filled waveguides (AWGs) rather than onto microstrip, or strip-line.

Such devices are frequently intended for use with associated antennas. Examples include 4G mobile communication transmitters, receivers and transceivers operating in a frequency range of, for example, 410 MHz to 6 GHz, and 5G new radio mobile communication devices operating in a similar frequency range (410 MHz to 7.125 GHz), as well as at higher frequencies (24.5 to 81 GHz). The millimetre wave or microwave signals may be transferred between the semiconductor device and the antenna through such AWG's. There is thus an increasing level of commercial interest in assemblies which can inexpensively provide an electrical connection, for the microwave or millimetre wave signals between the semiconductor die and the antenna or antennas, using AWG's. Furthermore, in order to make efficient use of the very expensive semiconductor die area, relatively close packing of the launchers-in-package may be desirable.

### SUMMARY

According to a first aspect of the present disclosure, there is provided an air-filled waveguide, AWG, assembly for use with a launcher-in-package semiconductor device, and comprising a stack of: a first laminate structure configured to be coupled to a semiconductor die, and having a first aperture therethrough; a second laminate structure affixed to the first laminate structure, having a second aperture, aligned with the first aperture, therethrough, and having a main AWG there-along; and a third laminate structure affixed to the second laminate structure, and having at least one bridging AWG there-along; wherein the AWG assembly is arranged to guide a microwave or millimetre-wave signal between the semiconductor die and the AWG in the second laminate structure, through the first and second aperture and along the bridging AWG. Inclusion of a bridging AWG may increase the design flexibility of the assembly, in a cost-effective method.

In one or more embodiments, the first laminate structure is affixed to the second laminate structure by means of solder tabs. Solder tabs are particularly convenient in order to assemble structures. Alternative embodiments may use different methods to affix the laminate structures to each other (whether the first laminate structure to the second laminate structure, or the second laminate structure to the third laminate structure). For example, and without limitation, solder balls, solder paste, or PCB pressing may be used as alternatives.

The AWG assembly may further comprise a first conductive substrate affixed between the second laminate structure and the third laminate structure, and having a third aperture therethrough aligned with the second aperture, wherein the first conductive substrate forms an upper wall of the bridging AWG. Without limitation, such a first conductive substrate may be, or may be replaced by, a copper layer, or a copper-cladded laminate. In one or more embodiments the first conductive substrate forms a lower wall of the main AWG. In this context "lower" will be understood to be the surface further away from the semiconductor die. In other words, references to "lower" and "upper" herein, refer to a configuration in which semiconductor die is affixed to, or is to be affixed to, the "top" of the stack of laminate structures. By using the substrate as upper or lower (or both) walls of one or more of the waveguides, fabrication may be made simpler, since the waveguide cavity may be formed in an individual laminate structure by drilling, milling or otherwise forming an aperture through the complete laminate structure, rather than needing to accurately control the depth of the aperture by, for instance, stopping at a metallised surface thereof.

The AWG assembly may further comprise a second conductive substate affixed to the third laminate structure, wherein the second conductive substate forms a lower wall of the bridging AWG. In one or more embodiments the third laminate structure is affixed to second conductive substrate, by means of solder tabs.

In one or more embodiments the first, second, and third laminate structures each comprise a metallised circuit board. In one or more such embodiments the metallised circuit boards may be metallised on both sides or faces.

The AWG assembly may further comprise a fourth aperture through the third laminate structure, at least partly aligned with an end of the main AWG. In one or more embodiments the main AWG is connected to an antenna.

In one or more embodiments the antenna is a slotted waveguide antenna formed in the second laminate structure and having slots in the first conductive substrate. The slotted waveguide antenna may be, or may comprise, radiating slots in the second laminate structure.

The AWG assembly may further comprise a recess in a surface thereof, for accommodating a surface mount component therein. In one or more such embodiments the recess may be in one of the first laminate structure and the third laminate structure. In one or more such embodiments the recess may extend through a one of the first laminate structure and the third laminate structure, and at least partly through the second laminate structure.

In one or more embodiments the second laminate structure further comprises a further AWG thereacross, wherein the bridging AWG crosses at least a part of the further AWG. In one or more such embodiments the further AWG is separated from the bridging AWG by the first conductive substrate.

According to a further aspect of the present disclosure, there is provided an assembly comprising: a packaged semiconductor device, comprising a semiconductor die and a launcher for a high frequency electromagnetic signal; and an air-filled waveguide, (AWG) assembly comprising a stack of: a first laminate structure configured to be coupled to a semiconductor die, and having a first aperture therethrough; a second laminate structure affixed to the first laminate structure, having a second aperture, aligned with the first aperture, therethrough, and having a main AWG there-along; and a third laminate structure affixed to the second laminate structure, and having at least one bridging AWG there-along; wherein the AWG assembly is arranged to guide the high frequency electromagnetic signal between the semiconductor die and the AWG in the second laminate structure, through the first and second aperture and along the bridging AWG.

In one or more embodiments the high frequency electromagnetic signal is a microwave signal or a millimetre wave signal. In one or more embodiments the semiconductor die comprises a radar signal processing integrated circuit. In one or more embodiments the semiconductor die comprises a transceiver.

### BRIEF DESCRIPTION OF THE DRAWINGS

Reference will now be made to the accompanying drawings, wherein:
FIG. 1 shows an exploded view, illustrating some aspects of an air-filled waveguide assembly (AWG) consistent with one or more aspects of the present disclosure;
FIG. 2 shows a cross-section through an AWG assembly according to one or more embodiments;
FIG. 3 shows another section through the AWG assembly of FIG. 2;
FIG. 4 shows a cross-section through an AWG assembly according to one or more other embodiments;
FIG. 5 show a partially schematic plan view of, and corresponding sections along and across, an AWG assembly according to one or more embodiments;
FIG. 6 shows a section through an AWG assembly affixed to semiconductor die 202, according to one or more other embodiments;
FIG. 7 shows another section through the AWG assembly of FIG. 6;
FIG. 8 show a partially schematic plan view of, and corresponding sections along and across, an AWG assembly according to one or more embodiments; and
FIG. 9 show a partially schematic plan view of, and corresponding sections along and across, an AWG assembly according to one or more other embodiments.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

### DETAILED DESCRIPTION

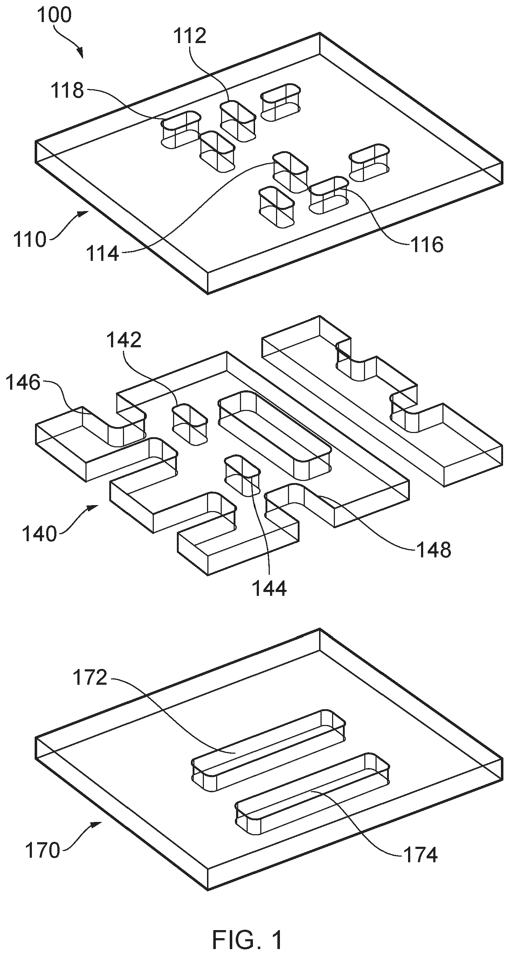

The subject disclosure describes, among other things, an air-filled waveguide, AWG, assembly 100 for use with a launcher-in-package semiconductor die. FIG. 1 shows an exploded view, illustrating some aspects of such an air-filled waveguide assembly. The AWG assembly 100 includes a first laminate structure 110, which may also be referred to as an application PCB or a top layer, together with a second laminate structure 140, which second laminate structure may also be referred to as an antenna PCB, and a third laminate structure, which may also be referred to as a bridge layer or bridging layer.

Each laminate structure comprises a generally planar electrically insulating dielectric material, with electrically conductive material on both surfaces, which may also referred to as sides or faces, thereof. The laminate structures may be circuit boards such as FR4, epoxy laminated fibreglass reinforced sheet boards, fabricated by conventional means, with copper or other conductive metal bonded to each of the top and bottom surface of the board.

The first laminate structure 110 or application PCB has one or more apertures 112, 114, 116 therethrough. The apertures 112, 114, 116, 118 are generally rectangular in section, and may have rounded shorter ends. The apertures may be aligned, that is to say they have their longer dimension in the same direction, or they may be orthogonal to each other. As shown in FIG. 1, apertures 112 and 114 are aligned with each other, and are orthogonal to apertures 116 and 118. The apertures are through the entire laminate structure. That is to say they extend through the upper and lower metal layers in addition to extending through the insulating board.

The sidewalls of the apertures 112, ... 118 are generally made to be conductive. This is typically achieved by plating, using either electroless plating technology, or electroplating technology, with a metal such as copper, although other metals are not excluded. It will be appreciated that other methods of depositing a conductive material at the sidewalls are not excluded.

The apertures 112, ... 118 are provided to allow a high frequency signal, typically in the millimetre or microwave frequency range, to travel between a semiconductor device or semiconductor die (not shown), located above the first laminate structure, and the second laminate structure 140. The apertures may be referred to as "air-filled" since they are not filled by any material, and are generally open to the atmosphere, as will be become more apparent hereinunder.

The second laminate structure 140 or antenna PCB, similarly, has one or more such apertures 142, 144 therethrough. Each aperture 142, 144 is aligned, in both X direction and Y direction (that is to say along and across the laminate structure) with a corresponding aperture 112, 114 in the first laminate structure 110. In particular, first aperture 112 is aligned with second aperture 142.

In addition to the apertures 142, 144 through the second laminate structure, the second laminate structure also has one or more AWGs 146, 148 therein or there-along. These AWGs in the second laminate structure 140 antenna PCB may be referred to as main AWG's. Their primary function is to route the high frequency signal away from (or towards) the semiconductor device or die (and the apertures through the first laminate structure 110) and corresponding antennas (not shown in FIG. 1). The AWGs are formed by open, generally elongate, channels or cut-outs in the second laminate structure 140. Both the apertures 142, 144 through the second laminate structure and the AWG's 146, 148 there-along, have electrically conductive sidewalls. Thus similar to the apertures through the first laminate structure 110, the sidewalls are made conductive, typically by plating with a metal such as copper.

The AWGs 146, 148 are generally aligned, at one end thereof, with a respectively aperture 116, 118 through the first laminate structure. In particular, the AWGs are each aligned width-wise with the corresponding aperture, and the aperture is either aligned or partially aligned with the end, lengthwise, of the AWG. Partial alignment, such that there is a step required for the transition from the vertical propagation of the signal (through aperture in the first laminate structure) to horizontal propagation (along the AWG in the second structure), has been shown to reduce the losses associated with the change in direction.

As shown in FIG. 1, the width of the AWG's 146, 148 may be in the same direction as the length (that is to say the larger dimension) of the rectangular apertures 116, 118. The skilled person will appreciate that in this configuration, the bend from the vertical propagation (through the top laminate) to the horizontal propagation (along the waveguide), is an "E-plane bend".. Alternatively, and not shown in FIG. 1, some or all of the AWGs may be aligned such that their width is in the same direction as the width (that is to say, the shorter dimension) of the rectangular apertures 116, 118; in that instance, the bend from the vertical propagation to the horizontal propagation is an "H-plane bend". In either case, the preferred waveguide propagation mode is the first transverse electric mode, TE10.

The third laminate structure 170 or bridging PCB, has one or more AWGs 172, 174 therein or there-along. It may also have apertures 176, 178 (not shown in FIG. 1) therethrough. The AWGs are formed by open, generally elongate, channels or cut-outs in the third laminate structure 170. Both the AWGs 172, 174 along the second laminate structure, and any apertures 176, 178 therethrough, have electrically conductive sidewalls. Similar to the apertures through the first laminate structure 110, the sidewalls are typically plated with a metal such as copper. The AWG's 172, and 174 may be referred to as bridging AWGs, as will become more apparent hereinunder. As will also become more apparent hereinunder, the provision of a third laminate structure 170 or bridging PCB allows for AWGs to, either partially or fully, overlap with each other, and to cross each other. In consequence, the launching ports in the semiconductor die or device may be more closely packed than would otherwise be the case, and it may be easier to configure the semiconductor die device to have a relatively smaller area than may otherwise be the case. Furthermore, the inclusion of bridging AWGs in the third laminate structure 170 may facilitate use of both E-plane or H-plane bends in the same semiconductor device or die, whilst maintaining a compact size of that semiconductor device or die.

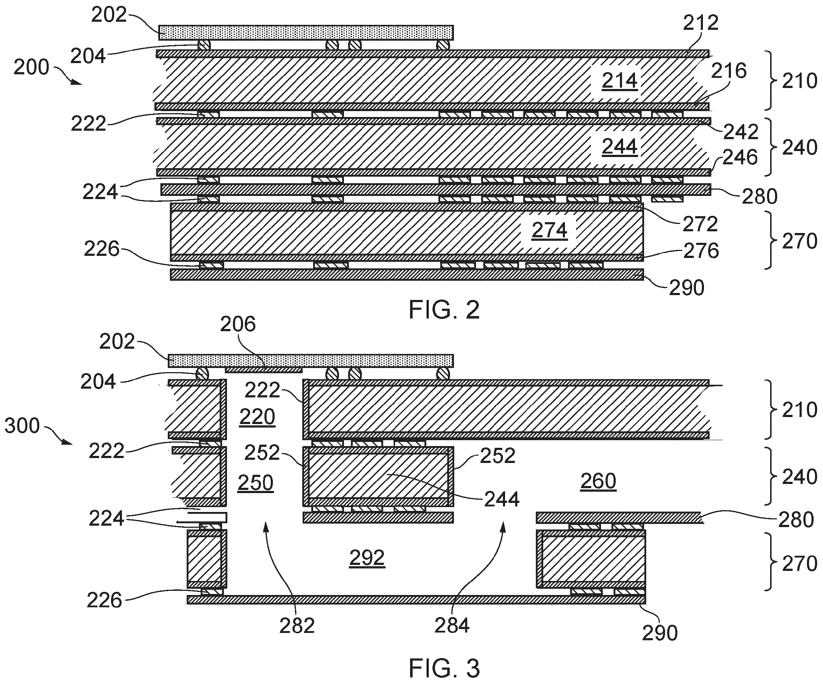

Considering FIG.2 and FIG. 3, FIG. 2 shows a cross-section 200 through an AWG assembly according to one or more embodiments, along a section which intersects neither aperture nor AWG; FIG. 3 shows a cross-section 300 through an AWG assembly according to one or more embodiments, along a section which intersects apertures, a main AWG and a bridging AWG.

FIG. 2 shows a stack of a first laminate structure 210 or application PCB, a second laminate structure 240 or antenna PCB, and a third laminate structure 270 or bridging PCB. Between the second laminate structure 240 and the third laminate structure 270 may be affixed a first substrate 280, and a second substrate 290 may be affixed below the third laminate structure 270, that is to say on the side remote from the second laminate structure 240. In a preferred process, the first substrate 280 is provided as part of the laminate structure 240, and the second substrate 290 is provided as part of the laminate structure 270 For ease of understanding, the substrates are not shown in FIG. 1. The first substrate 280 has cutouts therethrough, as will be seen in more detail with respect to FIG. 3. In embodiments such as that depicted in FIG.s 2 and 3, the second substrate is continuous, and may cover the complete surface of the third laminate structure 270. Alternatively, the second substrate may be smaller than the third laminate structure, provided that it covers any bridging AWG therein.

The first laminate structure 210 comprises an insulating material 214, such as FR4 circuit board, having an upper metal layer 212 thereon, and a lower metal layer 216 thereunder. Similarly, the second laminate structure 240 comprises an insulating material 244, such as FR4 circuit board, having an upper metal layer 242 thereon, and a lower metal layer 246 thereunder. Similarly, the third laminate structure 270 comprises an insulating material 274 with metal layer 272 thereon and metal layer 276 thereunder.

The first laminate structure 210 may be affixed to the second laminate structure 240 by means of solder tabs 222, the second laminate structure may be affixed to the first substrate 280, and the first substrate 280 affixed to the third laminate structure 270 by means of solder tabs 224, and the third laminate structure may be fixed to the second substrate 290 by means of solder tabs 226. The solder tabs 222 may provide electrical connection between the first and second laminate structures. The solder tabs 224 may provide electrical connection between the second laminate structure 240 and the substrate 280, and between the substrate 280 and the third laminate structure 270. The solder tabs 226 may provide electrical connection between the third laminate structure 270 and the second substrate 290. A semiconductor die 202 is affixed to the AWG assembly 202, for example by solder bumps or balls 204. Alternatively, and without limitation, the PCBs may be pressed together without solder balls or solder tabs therebetween.

The first substrate 280 is conductive, and may be, or may be replaced by, a copper layer, or a copper-cladded laminate, such as a further printed circuit board. The substrate may be affixed to both the second laminate structure 240 and the third laminate structure 270 by means of solder tabs 224 is shown in FIG. 2; alternately, and without limitation, the substrate may be 280 directly pressed to either the second laminate structure 240 or third laminate structure 270; since the first substrate 280 is conductive, direct pressing to one of the second laminate structure 240, or third laminate structure 270, may result in metal-to-metal bonding, thereby simplifing the manufacturing process, reducing the geometrical tolerances which may otherwise result from solder thickness variability, and reduce the number of solder tabs required. The first substrate may be affixed to the one of the second 240 and third, 270 laminate structures subsequent to waveguide slots being cut therein.

FIG. 3 shows the stack of the first laminate structure 210 or application PCB, the second laminate structure 240 or antenna PCB, and the third laminate structure 270 or bridging PCB. Between the second laminate structure 240 and the third laminate structure 270 is affixed the first substrate 280, and the second substrate 290 is affixed below the third laminate structure 270, that is to say on the side remote from the second laminate structure 240. The section shown in FIG. 3 intersects an aperture 220 through the first laminate structure, and aperture 250 through the second laminate structure, a bridging AWG 292 along the third laminate structure 270, and a main AWG 260 along the second laminate structure 240. The sidewalls of the aperture 220 are lined with metal 222, and the sidewalls of the aperture 250 are lined with metal 252. The end wall of the main AWG 260 is also lined with metal 252, and the end walls of the bridging AWG 292 are lined with metal. For completeness it is mentioned that the sidewalls of the main AWG 260 are also lined with metal 252, although this is not visible in the FIG., and the sidewalls of the AWG 292 are lined with metal (also not visible in FIG. 3). As shown in FIG. 3, the apertures 220 and 250 are aligned with a contact pad 206 on the semiconductor device, or die 202, where the contact pad 206 acts as a launcher for a high frequency (typically millimetre wave or microwave frequency) signal into the bridging AWG 292 through the apertures 220 and 250. The signal is propagated along the bridging AWG 292 until it reaches the end of that waveguide, where there is an opening 284 through the first substrate 280 at the end of the main AWG 260. The waveguide 292 thus bridges the section 248 of the second laminate structure. It is thus enabled that a further waveguide may be designed into that section 248 (for example, a second main AWG, which may propagate across the assembly, that is to say into or out of the plane of the FIG.) without interfering with the propagation of the signal along waveguide 260.

Although not shown in FIG. 3, the millimetre wave or microwave radiation may be transmitted from a side face of the second laminate structure 240 or antenna PCB, or from a lower surface thereof.

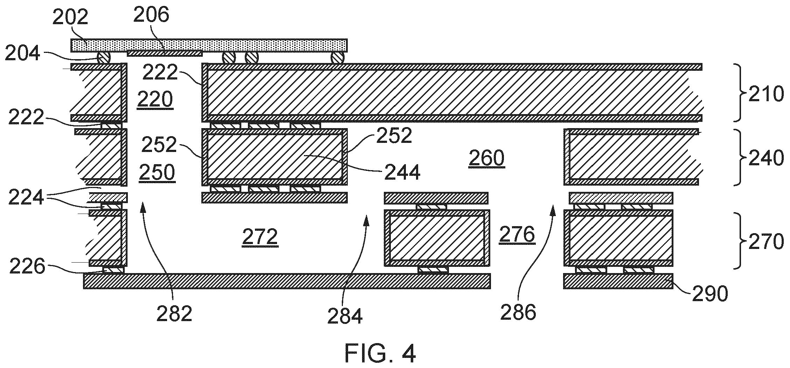

FIG. 4 shows a cross-section through an AWG assembly according to one or more other embodiments, along a section which intersects apertures, a bridging AWG, and a main AWG and a bridging AWG. The cross-section FIG.4 is similar to that shown in FIG.3, and like parts will not be described again. However, the section differs from that in FIG. 3, in that the millimetre wave or microwave signal is transmitted from the lower surface of bridging PCB or the third laminate structure 270. To enable this, there is a cutout 286 in the first substrate at an end of the main AWG 260 which is remote from the semiconductor device of die 202, and aligned with an aperture 276 through the third laminate structure 270 or bridging PCB.

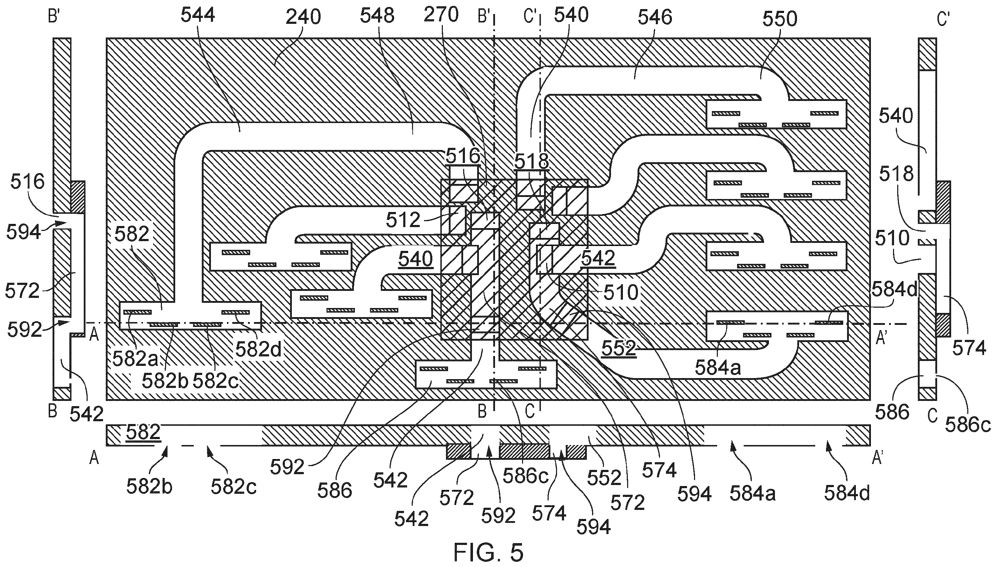

Turning now to FIG. 5, this illustrates a partially schematic plan view of, and corresponding sections along and across, an AWG assembly according to one or more embodiments. In particular, a schematic section along AA', is shown, together with schematic sections across BB' and CC'. Each of the sections intersects the bridging PCB or third laminate structure 270. For clarity reasons, only the antenna PCB or second laminate structure 240 and bridging PCB or third laminate structure are shown in the FIG., although the apertures through the application PCB or first laminate structure 210 are marked, as will be described in more detail below.

The FIG. shows main AWGs 540 and 542 along the second laminate structure 240, that is to say, up and down in the plane of the FIG. As can be seen in the FIG., some of the main AWG's, such as that depicted at 544 and 546, may extend across the second laminate structure 240 (that is to say, left to right in the plane of the FIG.). The FIG. illustrates a plurality of antennas 582, 584, 586. In this particular example, the antennas are slot antennas, in which each antenna includes a plurality of slots (such as those shown at 582a, 582b, 582c and 582d, and at 584a and 584d) which are elongate in the same direction (which, in the example shown, is across the assembly). The slots are formed from apertures through the first substrate. As can be seen in the FIG., the AWG's may include curved sections such as those shown at 548, 550, in order to effectively route the millimetre or microwave frequency signals between the slot antennas and the semiconductor die (not shown). As has already been described, the signal is routed between the AWG's and the semiconductor die via apertures in the first laminate structure 210 (not shown). The apertures are depicted in the FIGS., for example at 512 and 510.

The apertures through the application PCB or first laminate structure 210 are required to be aligned with launchers from the semiconductor device (not shown), and so it is desirable to pack the apertures as tightly together as is practicable or possible, so as to enable use of a semiconductor device which is a small as possible. As a result, routing of the signal along the AWG's becomes complex: by using bridging PCB or third laminate structure 270, and bridging AWG's there-along, the packing may be achieved which is more dense than would otherwise be the case, as can be seen from the FIG.

This is illustrated by, for example, aperture 516, which extends through application PCB or first laminate layer 240 (not shown), and through the antenna PCB or second laminate layer 240, and is aligned with the end of a bridging AWG 572. First substrate 280 includes a corresponding aperture or cut-out 594 aligned with the aperture 516. Bridging AWG 572 extends along the laminate, and at its distal end (that is to say, the end which is remote from semiconductor die). It is aligned with a main AWG, in this case, AWG 542. The RF signal is transferred from the bridging AWG to the main AWG (or vice versa) through an aperture 592 through the first substrate. A second bridging AWG 574 is also shown in the FIG. One end of the bridging AWG 574 is aligned with aperture 518 through the antenna PCB or second laminate structure 240, and aperture 518 extends (not shown through) the application PCB or first laminate structure 210 which is aligned with a launch pad, (not shown) from the semiconductor die (not shown). As has already been described, the distal end of the or each bridging AWG is aligned with an end of a main AWG. The RF signal is transferred from the bridging AWG to the main AWG (or vice versa) through an aperture 594 through the first substrate.

Whereas the bridging AWG 572 is straight and extends along the third laminate structure, as can be seen from the plan view in FIG. 5, the bridging AWG 574 includes a corner section (in this case, an approximately 60° bend). The main AWG 552 to which the bridging AWG 574 provides a path, extends, at least initially, in the same direction as the adjacent section of the bridging AWG.

The AWG assembly shown in FIG. 5 may correspond to the section shown in FIG. 3. In such examples, all of the slot antennas lie outside of the area covered by the bridging PCB or third laminate structure 270.

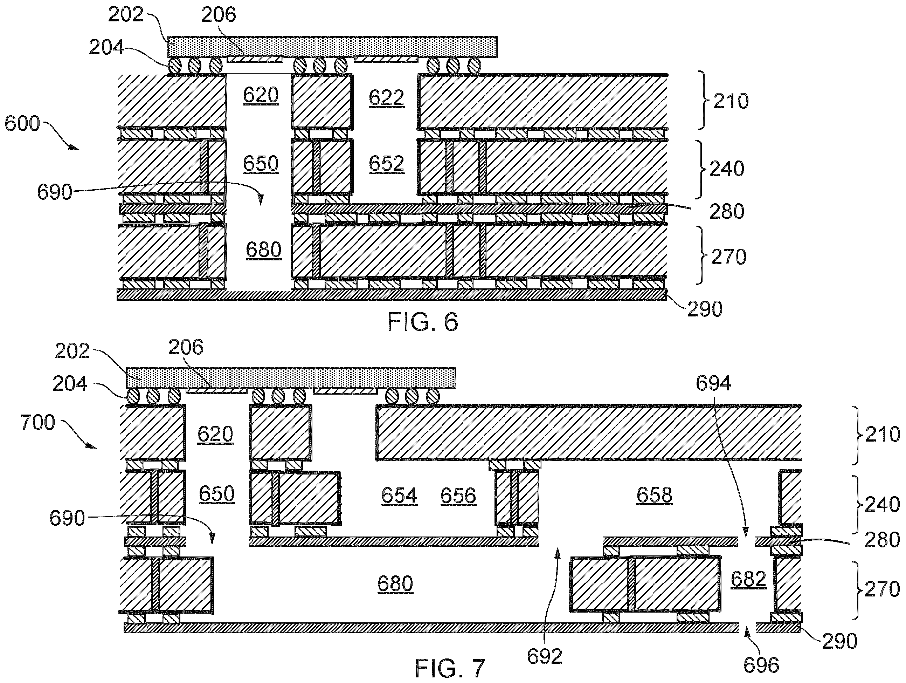

FIG. 6 and 7 show, respectively, sections through AWG assemblies 600, 700 respectively affixed to semiconductor die 202, according to one or more other or similar embodiments. Similar to those shown in FIG.s 2 and 3, the AWG assembly includes a stack of three laminate structures, 210, 240, 270, with a first or intermediate substrate 280 affixed between the second laminate structures 240, 270, and a second substrate affixed to the face of the third laminate structure, which is remote from a semiconductor die 202 which may be affixed to the first laminate structure by means of, for example, solder balls or bumps 204. The section shown in FIG. 6 includes a first aperture 620 through the first laminate structure 210, which aperture is aligned with a second aperture 650 through the second laminate structure 240, and an aperture or cut-out 690 through the first or intermediate substrate 280. The apertures are aligned with the end, 680, of a bridging AWG, which extends into or out of the plane of the FIG. The section shown in FIG. 6 includes a further aperture 622 through the first laminate structure 210, which is aligned with an end of a main AWG 652. Similar to bridging AWG 680, the main AWG 652 extends in or out of the plane of the FIG.

FIG. 7 shows another section through one or more such embodiments; the section may, without limitation, be orthogonal to the section shown in FIG. 6. The FIG. shows another aperture 624 through the first laminate structure 210, which is partially aligned with one end of a main AWG 654 which extends along the FIG. Although in the plane of FIG., the AWG 654 appears to terminate at an end region 656, in general, the main AWG is would not be a "blind" waveguide, or stub: instead, the end 656 of the main AWG 654 which is remote from the semiconductor die may typically include a curved section such that the AWG continues into or out of the plane of FIG.

The apertures 620 and 650 through the first and second laminate structures 210 240 can be seen, as can the aperture or cut-out 690 in the first substrate, and the bridging AWG 680, which extends along the plane of FIG. 7. At its remote end, it is partially aligned with a further aperture or cut out 692 in the first substrate, which in turn is aligned with one end of a second main AWG 658 in the second laminate structure 240. The "bridging" nature of the bridging AWG 680 is thus immediately apparent. In embodiments such as that shown in FIG. 7 differ from those shown in FIG. 3, in that the bridging PCB or third laminate structure 270 may extend over the whole of the second laminate structure 240. In such embodiments, the microwave or millimetre wave signals may be routed away from the main AWG either upwards through the first laminate structure (generally in a location which is separated from the semiconductor die), through the bridging PCB or third laminate structure 270. FIG. 7 shows an example of the last of these non-limiting alternatives. Thus, at the end of the second main AWG 658 is aligned to a further aperture 694 in the first or intermediate substrate 280, the aperture 694 is aligned with a further aperture or through-hole 682 through the third laminate structure 270, and with a further aperture or cut-out 696 through the second substrate 290. In general, aperture 694 will be a narrow slot, and aperture 696 will be a wider aperture forming part of a horn - in other words, the apertures may have different widths, although they may equally have the same width.

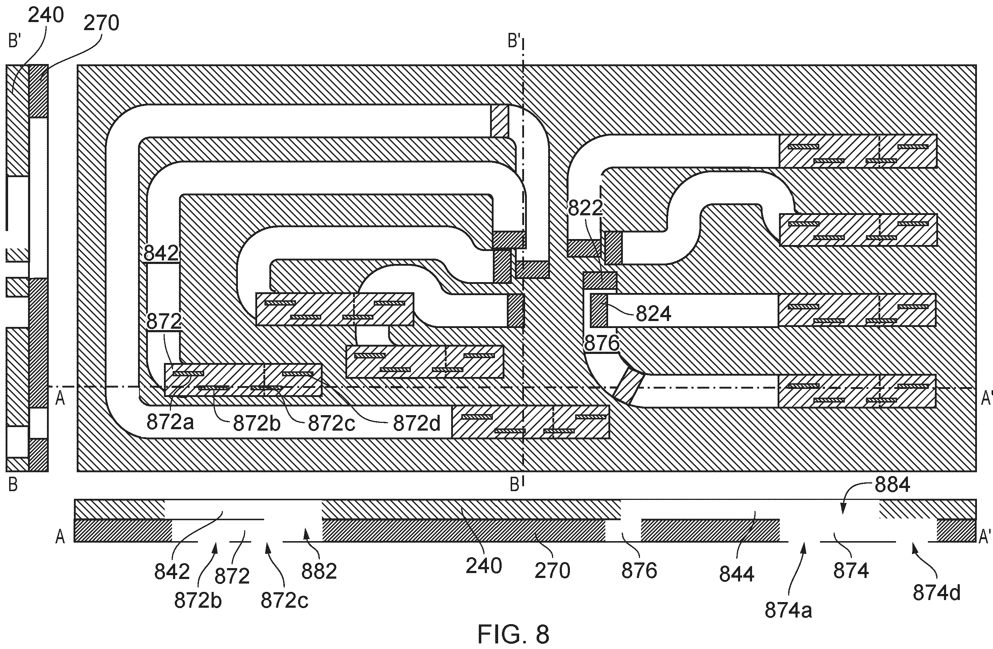

FIG. 8 show a schematic plan view of an embodiment in which the bridging PCB or third laminate structure 270 is larger than that shown in FIG. 5. In this example, it is the same size as the antenna PCB or second laminate structure 240. In particular, in this example, the slot antennas are provided in the bridging PCB, such that the cross-section is similar to that shown in FIG. 7. In embodiments such as that shown in FIG. 8, one or more main AWG's in the second laminate structure 240 may be used to provide the feeds for slot antennas, which slot antennas are constructed in the third laminate structure 270. This is visible, for example, in the section AA', in which it can be seen that there is a main waveguide 842, which feeds, through an aperture 882 in the first substrate, a slot antenna 872 (having individual slots 872a, 872b, 872c, 872d). In the cross-section, slots 872b, and 872c are visible in the second substrate 290. Similarly, main waveguide 844 in the second laminate structure 240 feeds slot antenna 874, (having individual slots 874a, 874b, 874c, 874d) in the third laminate structure 270 through aperture 884 in the second substrate 280. The skilled person will appreciate that the size of aperture 884 may help with the matching when going from the bottom layer 842 to antenna 872. The FIG. also illustrates a bridging waveguide 876 which allows close placement of apertures 822 and 824 (and thus allows corresponding close placement of the feed points on the semiconductor die), which might not otherwise be possible.

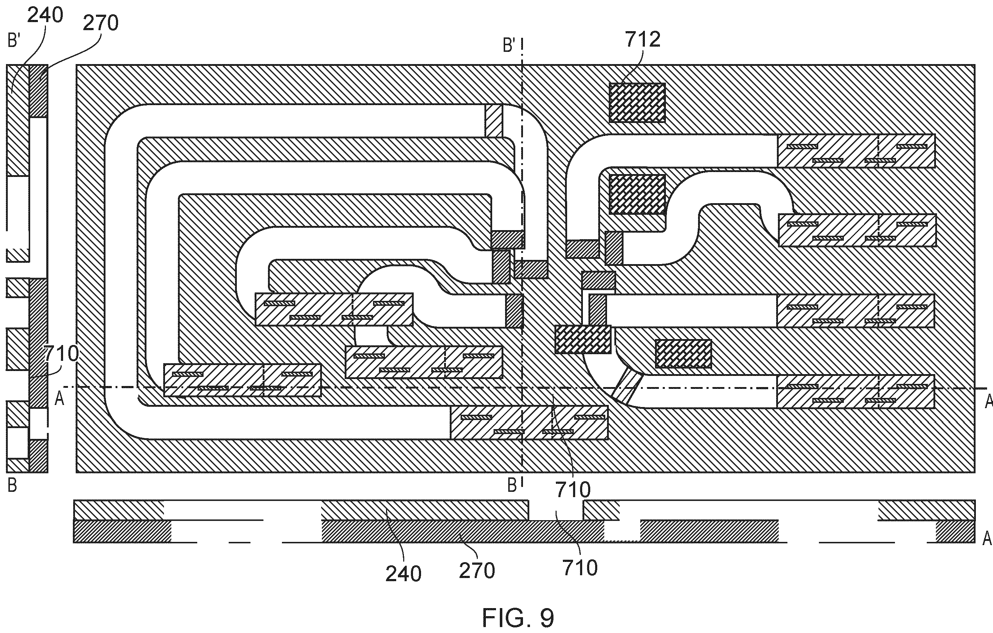

FIG. 9 shows a schematic plan view of an embodiment, which is similar to that shown in FIG. 8, except in this example, one or more of the laminate structures 240 and 270 include one or more recesses or apertures therein. The recesses or apertures may extend through a metal layer on one side of the laminate structure and the insulating material of the board to the metal layer on the other side of the laminate structure. In the example shown, apertures or recesses 710, 712 are shown in the antenna PCB or second laminate structure 240. In other embodiments, the recesses or apertures are provided in the bridging PCB or third laminate structure 270.

By now it will have been appreciated that, by providing an additional laminate structure, which can accommodate a bridging AWG, which is out of the plane of the main AWG AWG's, considerable flexibility has been added, compared to known approaches. The designer of assemblies may take advantage of this to increase the packing density of launch pads from the semiconductor die, which in turn may result in an increase saving. Moreover, the increased design flexibility may be advantageous in other respects. In particular, it may enable or facilitate a combination of E-plane and H-plane bends. Furthermore the skilled person will be aware that, in general, although transverse electric modes, and in particular, TE01, are generally less lossy, there may be occasions applications in which it is helpful to use TM01 waveguiding mode

The illustrations of embodiments described herein are intended to provide a general understanding of the structure of various embodiments, and they are not intended to serve as a complete description of all the elements and features of apparatus and systems that might make use of the structures described herein. Many other embodiments will be apparent to those of skill in the art upon reviewing the above description. Other embodiments may be utilized and derived therefrom, such that structural and logical substitutions and changes may be made without departing from the scope of this disclosure. FIG.s are also merely representational and may not be drawn to scale. Certain proportions thereof may be exaggerated, while others may be minimized. Accordingly, the specification and drawings are to be regarded in an illustrative rather than a restrictive sense.

Although specific embodiments have been illustrated and described herein, it should be appreciated that any arrangement calculated or constructed to achieve the same or a similar purpose may be substituted for the specific embodiments shown. This disclosure is intended to cover any and all adaptations or variations of various embodiments. Combinations of the above embodiments, and other embodiments not specifically described herein, are contemplated by the subject disclosure.

For instance, one or more features or aspects from one or more embodiments can be combined with one or more features or aspects of one or more other embodiments. In one or more embodiments, features that are positively recited can also be negatively recited and excluded from the embodiment with or without replacement by another structural and/or functional feature. The steps or functions described with respect to the embodiments of the subject disclosure can be performed in any order. The steps or functions described with respect to the embodiments of the subject disclosure can be performed alone or in combination with other steps or functions of the subject disclosure, as well as from other embodiments or from other steps that have not been described in the subject disclosure. Further, more than or less than all of the features described with respect to an embodiment can also be utilized.

Less than all of the steps or functions described with respect to the exemplary processes or methods can also be performed in one or more of the exemplary embodiments. Further, the use of numerical terms to describe a device, component, step or function, such as first, second, third, and so forth, is not intended to describe an order or function unless expressly stated so. The use of the terms first, second, third and so forth, is generally to distinguish between devices, components, steps or functions unless expressly stated otherwise. Additionally, one or more devices or components described with respect to the exemplary embodiments can facilitate one or more functions, where the facilitating (e.g., facilitating access or facilitating establishing a connection) can include less than every step needed to perform the function or can include all of the steps needed to perform the function.

The Abstract of the Disclosure is provided with the understanding that it will not be used to interpret or limit the scope or meaning of the claims. In addition, in the foregoing Detailed Description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus the following claims are hereby incorporated into the Detailed Description, with each claim standing on its own as a separately claimed subject matter.

## Claims

1. An air-filled waveguide, AWG, assembly for use with a launcher-in-package semiconductor device, and comprising a stack of:
a first laminate structure configured to be coupled to a semiconductor die, and having a first aperture therethrough;
a second laminate structure affixed to the first laminate structure, having a second aperture, aligned with the first aperture, therethrough, and having a main AWG there-along; and
a third laminate structure affixed to the second laminate structure, and having at least one bridging AWG there-along;
wherein the AWG assembly is arranged to guide a microwave or millimetre-wave signal between the semiconductor die and the AWG in the second laminate structure, through the first and second aperture and along the bridging AWG.

2. The AWG assembly of claim 1, wherein the first laminate structure is affixed to the second laminate structure by means of solder tabs.

3. The AWG assembly of claim 1 or 2, further comprising a first conductive substrate affixed between the second laminate structure and the third laminate structure, and having a third aperture therethrough aligned with the second aperture, wherein the first conductive substrate forms an upper wall of the bridging AWG.

4. The AWG assembly of claim 3, wherein the first conductive substrate forms a lower wall of the main AWG.

5. The AWG assembly of any preceding claim, further comprising a second conductive substate affixed to the third laminate structure, wherein the second conductive substate forms a lower wall of the bridging AWG.

6. The AWG assembly of any preceding claim, wherein the third laminate structure is affixed to second conductive substrate by solder tabs.

7. The AWG assembly of any preceding claim, wherein the first, second, and third laminate structures each comprise a metallised circuit board.

8. The AWG assembly of claim 7, wherein the metallised circuit boards are metallised on both sides.

9. The AWG assembly of any preceding claim, further comprising a fourth aperture through the third laminate structure, at least partly aligned with an end of the main AWG.

10. The AWG assembly of any of claims 1 to 8, wherein the main AWG is connected to an antenna.

11. The AWG assembly of claim 10, when dependant on claim 3, wherein the antenna is a slotted waveguide antenna formed in the second laminate structure and having slots in the first conductive substrate.

12. The AWG assembly of any preceding claim, further comprising a recess in one surface thereof, for accommodating a surface mount component therein.

13. The AWG assembly of claim 12, wherein the recess is in one of the first laminate structure and the third laminate structure.

14. The AWG assembly of claim 12, wherein the recess extends through a one of the first laminate structure and the third laminate structure, and at least partly through the second laminate structure.

15. The AWG assembly of any preceding claim, wherein the second laminate structure further comprises a further AWG thereacross, wherein the bridging AWG crosses at least a part of the further AWG.

## Amended claims

### Amended claims in accordance with Rule 137(2) EPC.

1. An air-filled waveguide, AWG, assembly (100) for use with a launcher-in-package semiconductor device, and comprising a stack of:
a first laminate structure (110) configured to be coupled to a semiconductor die (202), and having a first aperture (220) therethrough;
a second laminate structure (140) affixed to the first laminate structure, having a second aperture (250), aligned with the first aperture, therethrough, and, in addition to the second aperture, having a main AWG (654) there-along;
a third laminate structure (170) affixed to the second laminate structure, and having at least one bridging AWG (292) there-along; and
further comprising a first conductive substate (290) affixed to the third laminate structure, wherein the first conductive substate forms a lower wall of the bridging AWG;
wherein the AWG assembly is arranged to guide a microwave or millimetre-wave signal between the semiconductor die and the AWG in the second laminate structure, through the first and second aperture and along the bridging AWG.

2. The AWG assembly of claim 1, wherein the first laminate structure is affixed to the second laminate structure by means of solder tabs.

3. The AWG assembly of claim 1 or 2, further comprising a second conductive substrate (280) affixed between the second laminate structure and the third laminate structure, and having a third aperture therethrough aligned with the second aperture, wherein the second conductive substrate forms an upper wall of the bridging AWG.

4. The AWG assembly of claim 3, wherein the second conductive substrate forms a lower wall of the main AWG.

5. The AWG assembly of any preceding claim, wherein the third laminate structure is affixed to second conductive substrate by solder tabs.

6. The AWG assembly of any preceding claim, wherein the first, second, and third laminate structures each comprise a metallised circuit board.

7. The AWG assembly of claim 7, wherein the metallised circuit boards are metallised on both sides.

8. The AWG assembly of any preceding claim, further comprising a fourth aperture through the third laminate structure, at least partly aligned with an end of the main AWG.

9. The AWG assembly of any of claims 1 to 7, wherein the main AWG is connected to an antenna.

10. The AWG assembly of claim 9, when dependant on claim 3, wherein the antenna is a slotted waveguide antenna formed in the second laminate structure and having slots in the first conductive substrate.

11. The AWG assembly of any preceding claim, further comprising a recess in one surface thereof, for accommodating a surface mount component therein.

12. The AWG assembly of claim 11, wherein the recess is in one of the first laminate structure and the third laminate structure.

13. The AWG assembly of claim 11, wherein the recess extends through a one of the first laminate structure and the third laminate structure, and at least partly through the second laminate structure.

14. The AWG assembly of any preceding claim, wherein the second laminate structure further comprises a further AWG thereacross, wherein the bridging AWG crosses at least a part of the further AWG.
